# EUROPÄISCHE PATENTANMELDUNG

(11) **EP 4 398 282 A2**
(43) Veröffentlichungstag der Anmeldung: **10.07.2024**
(21) Anmeldenummer: 24169826.5
(22) Anmeldetag: 08.11.2019
(51) Int. Cl.: H01J 37/28

(54) **VERFAHREN ZUR ELEKTRISCHEN UNTERSUCHUNG VON ELEKTRONISCHEN BAUELEMENTEN EINES INTEGRIERTEN SCHALTKREISES**

(30) Priorität: 07.12.2018 DE 102018009623
(62) Teilanmeldung aus: 19809377.5
(71) Anmelder: Forschungszentrum Jülich GmbH, 52425 Jülich (DE)
(72) Erfinder: Voigtländer, Bert, 52428 Jülich (DE); Cherepanov, Vasily, 52428 Jülich (DE)

(57) **Zusammenfassung**

Die Erfindung betrifft ein Verfahren zur elektrischen Untersuchung von elektronischen Bauelementen eines integrierten Schaltkreises.

Erfindungsgemäß wird ein Verfahren zur elektrischen Untersuchung von elektronischen Bauelementen eines integrierten Schaltkreises (1), umfassend einen zu untersuchenden Zielbereich (3), in welchem sich elektronische Bauelemente mit Kontaktstellen (5) befinden, und einen restlichen Bereich, der als Nicht-Zielbereich (2) bezeichnet wird, zur Verfügung gestellt, bei dem mit einem kombinierten SEM/AFM-Nanoprober eine Untersuchung durchgeführt wird, wobei der Nicht-Zielbereich (2) in einem ersten Schritt mit dem Rasterelektronenmikroskop-Teil des SEM/AFM-Nanoprobers wenigstens teilweise abgebildet wird und der Zielbereich (3) in einem nachfolgenden Schritt mit dem Rasterkraftmikroskopischen Teil des SEM/AFM-Nanoprobers wenigstens teilweise abgebildet wird.

## Beschreibung

Die Erfindung betrifft ein Verfahren zur elektrischen Untersuchung von elektronischen Bauelementen eines integrierten Schaltkreises.

In der Halbleiterindustrie und an Forschungsinstituten werden Nanoprober eingesetzt, um integrierte Schaltkreise in der Fehleranalyse und bei Prozessoptimierung elektrisch zu charakterisieren. Dazu werden Messspitzen direkt an die Kontakte elektronischer Bauelemente, von integrierten Schaltkreisen, wie z.B. Transistorstrukturen, herangefahren und dann die elektrischen Eigenschaften dieser Bauelemente z.B. anhand von Kennlinien vermessen.

Es werden dabei unterschiedliche Arten von Nanoprobern eingesetzt, nämlich Rasterelektronenmikroskop-basierte (SEM) und Rasterkraftmikroskop-basierte (AFM) Nanoprober.

Beide Arten von Nanoprobern haben ihre spezifischen Vor- und Nachteile.

Die Vorteile eines SEM basierten Nanoprobers sind insbesondere (a) die schnelle Abbildung innerhalb weniger Sekunden und (b) die Möglichkeit eines Zooms vom mm Bereich bis in den nm Bereich, was eine einfache Positionierung der Messspitzen zu den Kontakten ermöglicht, sowie (c) die Vermeidung von lateralen Leckströmen, die bei AFM Nanoprobern an der Luft auftreten können.

Die wesentlichen Vorteile des AFM-basierten Nanoprobers sind (a) die Kontaktierung der zu vermessenden Probe unter Kraftkontrolle, die ein Verbiegen oder Abbrechen der Spitzen beim Aufsetzen auf isolierenden Stellen vermeidet und (b) parallel zur Topographie-Abbildung kann ein empfindliches elektrisches Signal detektiert werden (Conductive AFM).

Beim Nanoprobing mit einem SEM basierten Nanoprober und auch mit einem Nanoprober, der die Verfahren SEM und AFM kombiniert, wird die zu untersuchende Probe mit einem Elektronenmikroskop abgebildet und damit auch mit einem Elektronenstrahl bestrahlt. Bei der Kontaktierung von Bauelementen bzw. Transistorstrukturen mit den Tastspitzen eines Nanoprobers werden deren Positionen untereinander und relativ zu dem zu kontaktierenden Bauelement durch fortwährende Abbildung mit einem SEM beobachtet bzw. kontrolliert. Dabei wird die Fähigkeit des Rasterelektronenmikroskops zur schnellen Abbildung und zum schnellen Zoom vom Millimeterbereich über den Mikrometerbereich zum Nanometerbereich ausgenutzt. Die Scanning probe microscopy hat einen kleinen Zoom, also keine Abbildung im Millimeterbereich, und eine wesentlich langsamere Abbildung.

Es ist bekannt, dass die elektrischen Eigenschaften der Bauelemente durch den hochenergetischen Elektronenstrahl während Abbildung mit dem SEM geschädigt werden können. Beispielhaft wird dies in der Veröffentlichung "Investigation on the Influence of Focused Electron Beam on Electrical Characteristics of Integrated Devices" von S. Doering, R. Harzer und W. Werner, Qimonda Dresden GmbH & Co OHG, Dresden, Germany, Proceedings of the 33rd International Symposium for Testing and Failure Analysis (ISTFA), Band 33, Seite 210, November 4-6, 2007, McEnery Convention Center, San José, California, USA beschrieben.

Um diese Strahlungsschäden zu reduzieren, wurden in den letzten Jahren die Strahlenergien für die Elektronenmikroskop-Abbildung immer weiter reduziert. Derzeit werden bei der SEM Abbildung typischerweise Strahlenergien von 500 eV verwendet. Allerdings können selbst bei diesen geringen Energien noch Strahlenschäden auftreten. Das Problem wurde also nicht gelöst, sondern nur reduziert.

In der Patentanmeldung US 20150377921 A1 wird ein Nanoprober beschrieben, welcher eine Kombination aus SEM- und AFM-Nanoprobern darstellt.

In dem Patent US 8,536,526 B2 wird beschrieben, wie mit einem SEM-basierten Nanoprober eine gegenüber dem Elektronenstrahl empfindliche Region von der Bestrahlung durch den Elektronenstrahl ausgenommen wird.

In dem im Patent US 8,536,526 B2 beschriebenen Verfahren wird nur die äußere Hälfte der Kontakte, die gerade außerhalb des angenommenen Bereichs mit der empfindlichen Bauelementstruktur liegt, bestrahlt. Somit erscheinen die Kontakte im Bild des SEM-Nanoprobers zur Hälfte und die Messspitzen können unter Kontrolle zu diesen Kontakten positioniert werden. Eine Limitierung der in der US 8,536,526 B2 beschriebenen Methode, um sensitive Bereiche von der Bestrahlung durch den Elektronenstrahl auszusparen, ist, dass die Kontakte, über die die empfindliche Bauelementstruktur kontaktiert wird, oft sehr nah an der empfindlichen Bauelementstruktur liegen, die von der Bestrahlung durch den Elektronenstrahl ausgespart werden soll. Die in der Schrift US 8,536,526 B2 beschriebene Methode, sensitive Bereiche von der Bestrahlung durch den Elektronenstrahl auszusparen, ist nicht allgemein anwendbar, weil die Kontakte oft voll innerhalb des Bereiches der empfindlichen Bauelementstruktur liegen. In der praktischen Anwendung führt dies dazu, dass empfindliche Teile von elektronischen Bauelementen, wie Transistoren oder Dioden, trotzdem einer Beschädigung ausgesetzt sind. Wenn dieser Bereich bei der Abbildung mit SEM-Nanoprobern ausgespart wird, sind diese Kontakte im SEM-Bild nicht sichtbar und das SEM- Bild kann nicht für die Kontrolle der Position der Spitzen zu den Kontakten innerhalb des Bereiches der empfindlichen Bauelementstruktur herangezogen werden.

Für die Anwendung aus der Halbleiterindustrie ist eine Kombination der beiden Arten von Nanoprobern und deren Vorteilen wünschenswert. Es ist extrem wünschenswert, sowohl die jeweiligen Vorteile beider Verfahren auszunutzen als auch die jeweiligen Nachteile zu vermeiden.

Die Schrift DE 11 2014 002 074 T5 offenbart ein Verfahren zur Durchführung einer Sondenuntersuchung von Proben mit einem nicht interessierenden Teil und einem ROI, welches ein sensitives Bauteil sei kann, bei dem der nicht interessierende Teil mit einem SEM gescannt wird.

In der Veröffentlichung "Advanced electrical analysis of embedded memory cells using Atomic Force Probing" von M. Grützner in der Zeitschrift Microelectronics Reliability, 45 (2005) 1509-1513 wird ein Verfahren offenbart, mit dem Transistoren nicht-destruktiv Rasterkraftmikroskopisch abgebildet werden können.

Die Offenlegungsschrift DE 10 2015 216 673 A1 offenbart ein Verfahren und eine Vorrichtung zum Untersuchen einer Probenoberfläche, mit einem geladenen Teilchenstrahl und/oder einem Rastersondenmikroskop, deren Oberfläche eine elektrische Potentialverteilung aufweist.

Es ist daher die Aufgabe der Erfindung ein Verfahren zur elektrischen Untersuchung, insbesondere zur Qualitätskontrolle von elektronischen Bauelementen bereit zu stellen, welches die Vorteile beider Verfahren und Vorrichtungen kombiniert, wobei die jeweiligen Nachteile vermieden werden sollen. Insbesondere soll eine Veränderung der elektrischen Eigenschaften von Bauelementen durch Elektronenstrahlen vermieden werden.

Ausgehend vom Oberbegriff des Anspruchs 1 wird die Aufgabe erfindungsgemäß gelöst durch die im kennzeichnenden Teil angegebenen Merkmale.

Mit dem erfindungsgemäßen Verfahren ist es nunmehr möglich die Vorteile beider Technologien zu kombinieren und dabei die jeweiligen Nachteile zu vermeiden. Insbesondere wird die Beschädigung der zu vermessenden Bauelemente durch den Elektronenstrahl vermieden.

Vorteilhafte Ausgestaltungen der Erfindung sind in den Unteransprüchen angegeben.

Im Folgenden wird das erfindungsgemäße Verfahren in seiner allgemeinen Form beschrieben, ohne dass dies einschränkend auszulegen ist.

Erfindungsgemäß werden Bauelemente eines integrierten Schaltkreises, welcher eine Oberfläche besitzt, auf der oder unter der sich elektrisch zu untersuchende Bauelemente befinden, welche bei Einwirkung von Elektronenstrahlen strahlungsempfindlich sind und beschädigt werden können oder in ihrer ursprünglichen Beschaffenheit, ohne Einwirkung von äußeren Faktoren untersucht werden sollen, elektrisch untersucht. Diese Bereiche können beispielsweise Bauelemente, wie Kondensatoren, Wiederstände, Transistoren oder Dioden und Zusammenschaltungen zwischen ihnen enthalten.

Der Oberflächenbereich des integrierten Schaltkreises, in dem sich oder unterhalb dessen Oberfläche sich die zu untersuchenden Bauelemente befinden, wird als Zielbereich bezeichnet. Innerhalb dieses Zielbereichs befinden sich dann Kontaktstellen, die eine Untersuchung von Bauelementen, wie Kondensatoren, Wiederstände, Transistoren oder Dioden ermöglichen.

Bei den Kontaktstellen handelt es sich in der allgemeinsten Form um Stellen, an denen ein elektrischer Kontakt zu elektrischen Bauelementen hergestellt wird. Beispielhaft kann es sich dabei um sich auf dem intergierten Schaltkreis befindende metallische-, insbesondere Wolfram-Kontakte handeln.

Die Oberfläche des integrierten Schaltkreises, die außerhalb des Zielbereiches liegt, wird als Nicht-Zielbereich definiert.

Erfindungsgemäß wird zuerst der Nicht-Zielbereich des elektronischen integrierten Schaltkreises mit dem Rasterelektronenmikroskop-Teil eines SEM/AFM Nanoprobers wenigstens teilweise oder auch vollständig abgebildet. Dieser wird im Folgenden verkürzt als SEM bezeichnet. Die Spitzen des Nanoprobers werden dem Zielbereich angenähert.

Dabei ist es möglich, zuerst Bereiche, die weiter von dem Zielbereich entfernt sind, mit dem Rasterelektronenmikroskop abzubilden, um dann in kleinen Schritten die Positionen der Spitzen an den äußeren Rand des Zielbereichs anzunähern. Die Lage des Zielbereichs ist dabei in der Regel bekannt oder annähernd bekannt.

Die Annäherung an den Zielbereich kann dabei auf unterschiedliche Weise erfolgen.

Zum Beispiel kann das SEM mindestens eine Teilfläche des elektrischen Nicht-Zielbereiches in Trajektorien abfahren und den Elektronenstrahl des SEM's ausschalten, wenn der Zielbereich erreicht wird und wieder einschalten, wenn der Nicht-Zielbereich erreicht wird.

Es ist auch möglich, einen kontinuierlichen Elektronenstrahl des SEM's in Trajektorien auf dem integrierten Schaltkreis herum zu führen und die Richtung des Elektronenstrahls umzudrehen, wenn der Zielbereich erreicht wird.

Es ist auch möglich, den Elektronenstrahl des SEM's spiralförmig um den Zielbereich herumzuführen. Dabei ist es möglich, zuerst Bereiche, die weiter von dem Zielbereich entfernt sind, mit dem Rasterelektronenmikroskop abzubilden, um dann in kleinen Schritten die Positionen der Spitzen an den äußeren Rand des Zielbereichs anzunähern.

Vorzugsweise kann dabei die SEM Abbildung und die nachfolgende Re-Positionierung der Spitzen dazu genutzt werden, die Spitzen Schritt für Schritt an den Rand des Zielbereiches heranzuführen. Damit wird die Abbildung mit dem SEM nur außerhalb des Zielbereiches durchgeführt, so dass keine Qualitätsminderung oder Zerstörung bzw. eine Veränderung der Bauelemente erfolgt. Bauelemente können so elektrisch untersucht werden, ohne dass eine Veränderung des ursprünglichen Zustandes eintritt.

Damit wird die Untersuchung mit dem SEM so nah an den Zielbereich des elektronischen Bauelements durchgeführt, dass noch keine Qualitätsminderung oder Zerstörung bzw. eine Veränderung Bauelements erfolgt. Das ist beispielsweise bei einem Abstand von 50 nm bis 10 nm vom Rand des Zielbereichs der Fall. Bauteile können untersucht werden, ohne dass eine Veränderung des ursprünglichen Zustandes eintritt.

Die Abbildung des Zielbereichs wird nur mit dem rasterkraftmikroskopischen Teil des kombinierten SEM/AFM-Nanoprobers wenigstens teilweise oder vollständig durchgeführt, um Strahlungsschäden an den Bauelementen, die sich auf dem Zielbereich oder unterhalb des Zielbereiches befinden, durch eine SEM Abbildung zu vermeiden. Der rasterkraftmikroskopische Teil des kombinierten SEM/AFM Nanoprobers wird in einer verkürzten Benennung als AFM bezeichnet. Unter AFM Kontrolle der Positionen der Spitzen werden die Messspitzen zur Durchführung von elektrischen Messungen an Kontaktstellen im Zielbereich herangeführt, um an diesen die elektrische Messung mit den jeweiligen Spitzen durchzuführen.

Mit Hilfe der AFM Abbildungen der einzelnen Spitzen können die einzelnen Spitzen zu den gewünschten Stellen, beispielsweise zu den Kontaktstellen, geführt werden, und dort elektrische Messungen durchgeführt werden. Die Messung an den Kontaktstellen ermöglicht eine Bewertung der sich darunter befindenden funktionellen Bauelemente, wie beispielsweise Kondensatoren, Transistoren, Wiederstände und Dioden.

Es ist auch möglich, dass die Abbildung mit dem AFM Flächenelemente des integrierten Schaltkreises umfasst, welche wenigstens teilweise zu dem Zielbereich, jedoch auch wenigstens teilweise zu dem Nicht-Zielbereich gehören.

Erfindungsgemäß werden der Oberflächenbereich oder die Oberflächenbereiche, die als Zielbereich identifiziert wurden, nur mit dem Rasterkraftmikroskop Teil des Nanoprobers abgebildet. Dabei wird die Position der Messspitzen bzw. der Abstand der Messspitzen von der Oberfläche des integrierten Schaltkreises mittels des SEM ermittelt.

Zur Durchführung der elektrischen Untersuchung werden (a) die Spitzen unter Kontrolle durch AFM Abbildung zu den Kontaktstellen positioniert und (b) die Spitzen an den Kontaktstellen abgesenkt, um einen für die nachfolgenden elektrischen Messungen ausreichenden Kontakt zu den Kontaktstellen herzustellen und (c) dann die elektrische Untersuchung durchzuführen.

Über die Messspitzen werden dann die Kennlinien aufgenommen. Die Aufnahme der Kennlinien kann über den gesamten Zielbereich oder Teile davon erfolgen.

Die Aufnahme von Kennlinien beinhaltet eine oder mehrere Strom-Spannungskurven, die entweder durch das Anlegen einer Spannung und der Messung von Strömen oder das Injizieren eines Stroms und der Messung der resultierenden Spannungen ermittelt wird.

Weiterhin können elektrische Eigenschaften des integrierten Schaltkreises auch durch die conductive AFM Technik untersucht werden. Der Zielbereich soll nicht mit dem Elektronenstrahl bestrahlt (abgebildet) werden, um eine Veränderung der elektrischen Eigenschaften der Bauelemente des integrierten Schaltkreises unterhalb der Oberfläche und an der Oberfläche des Zielbereiches zu vermeiden, damit es in seiner ursprünglichen Beschaffenheit, ohne Einwirkung von äußeren Faktoren, untersucht werden kann.

Das erfindungsgemäße Verfahren ermöglicht eine Untersuchung, insbesondere eine Qualitätskotrolle, von elektronischen Bauelementen in integrierten Schaltkreisen, unter Vermeidung von Strahlenschäden durch Elektronenstrahlen durch eine Kombination von sowohl einer rasterelektronenmikroskopischen als auch einer rasterkraftmikroskopischen Abbildung der Probenoberfläche. Dies gilt insbesondere für den sehr oft auftretenden Fall, dass die mit den Spitzen zu kontaktierenden Kontaktstellen vollständig innerhalb des Zielbereichs liegen.

In den Figuren und der Tabelle sind vergleichende Angaben zu verschiedenen Verfahren, sowie ein elektronisches Bauelement dargestellt, welches mit dem erfindungsgemäßen Verfahren untersucht wird.

Es zeigt:
Tabelle 1: Eine Gegenüberstellung der Vorteile von verschiedenen Verfahren und dem erfindungsgemäßen Verfahren.

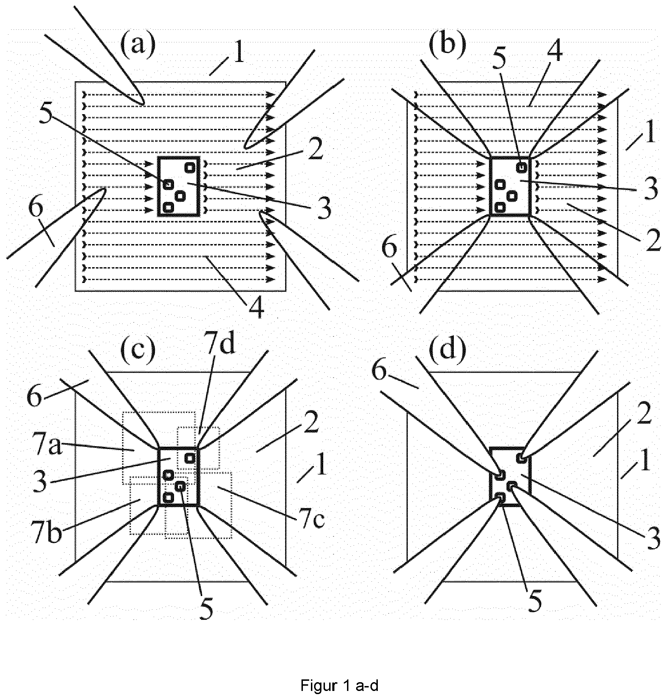

Fig. 1a-d: Ein integrierter Schaltkreis, auf welchem Trajektorien des Elektronenstrahls für die Abbildung mit dem Rasterelektronenmikroskop, sowie der Zielbereich und die Spitzen dargestellt sind.

In Figur 1a) ist eine Probe in Form eines integrierten Schaltkreises 1 dargestellt, der in einen Nicht-Zielbereich 2 und Zielbereich 3 aufgeteilt ist. Die horizontal gestrichelten Linien in dem Nicht-Zielbereich 2 bezeichnen eine Trajektorie 4, welche den Weg darstellt, entlang derer der Elektronenstahl während der rasterelektronenmikroskopischen Abbildung in dem Nicht-Zielbereich 2 geführt wird. In dem Zielbereich 3 sind Kontaktstellen 5 eingezeichnet. In dem Zielbereich erfolgt die Abbildung nur mit einem AFM-Teil des Nanoprobers, dessen Spitzen mit dem Bezugszeichen 6 gekennzeichnet sind.

In Figur 1b) haben gleiche Bestandteile der zu untersuchenden Probe dieselben Bezugszeichen. In ihr sind die Spitzen 6 des Nanoprobers an die Eckpunkte des Zielbereiches 3 herangeführt.

In Figur 1c) sind Flächenelemente 7a, 7b, 7c und 7d dargestellt, welche von den Spitzen 6 des Nanoprobers im Rasterkraftmikroskopiemodus abgebildet werden und die neben Teilberieche des Zielbereiches 3, in denen sich die Kontaktstellen 5 befinden, auch Bereiche des Nicht-Zielbereiches 2 umfassen.

Figur 1 d) zeigt eine Darstellung, in der sich die Spitzen 6 des Nanoprobers auf den Kontaktstellen 5 befinden.

**Tabelle 1**

| Vorteile | SEM | AFM | SEM/AFM |
|---|---|---|---|
| Schnelle Abbildung, Zoom vom mm- Bereich bis nm -Bereich | Ja | Nein | Ja |
| Vermeidung von Leckströmen an der Luft | Ja | Nein | Ja |
| Empfindliches elektrisches Signal während der Topographie-Abbildung | Nein | Ja | Ja |
| Kein Verbiegen oder Abbrechen von Spitzen, Abbildung mit der Spitze | nein | Ja | Ja |
| Vermeidung von Strahlenschäden | nein | ja | ja |

## Patentansprüche

1. Verfahren zur elektrischen Untersuchung von elektronischen Bauelementen eines integrierten Schaltkreises (1), umfassend einen zu untersuchenden Zielbereich (3), in welchem sich elektronische Bauelemente mit Kontaktstellen (5) befinden, und einen restlichen Bereich, der als Nicht-Zielbereich (2) bezeichnet wird,
bei dem mit einem kombinierten SEM/AFM-Nanoprober eine Untersuchung durchgeführt wird, wobei mindestens ein Teil des Nicht-Zielbereiches (2) in einem ersten Schritt mit dem Rasterelektronenmikroskop-Teil des SEM/AFM-Nanoprobers abgebildet wird und wenigstens ein Teil des Zielbereiches (3) in einem nachfolgenden Schritt nur mit dem Rasterkraftmikroskopischen Teil des SEM/AFM-Nanoprobers abgebildet wird und in einem weiteren nachfolgenden Schritt mit dem Nanoprober Strom-Spannungskurven als elektrische Kennlinien an den Kontaktstellen aufgenommen werden oder eine conduktive AFM Technik durchgeführt wird,
**dadurch gekennzeichnet,**
**dass** ein kontinuierlicher Elektronenstrahl des Rasterelektronenmikroskopischen Teils des SEM/AFM Nanoprobers in Trajektorien auf dem integrierten Schaltkreis herumgeführt wird der seine Richtung ändert, wenn er den Zielbereich (3) erreicht

2. Verfahren nach Anspruch 1,
**dadurch gekennzeichnet,**
**dass** die elektronischen Bauelemente des Zielbereiches (3) mindestens eine Komponente aus der Gruppe von Dioden, Transistoren, Wiederstände und Kondensatoren sind.

3. Verfahren nach einem der Ansprüche 1 oder 2 ,
**dadurch gekennzeichnet,**
**dass** die Untersuchung des integrierten Schaltkreises (1) mit dem Rasterelektronenmikroskop-Teil des SEM/AFM-Nanoprobers zuerst in Bereichen durchgeführt wird, welche weiter von dem Zielbereich (3) entfernt sind, und der Elektronenstrahl des Rasterelektronenmikroskop-Teils des SEM/AFM-Nanoprobers dem Zielbereich (3) in kleinen Schritten angenähert wird.

4. Verfahren nach Anspruch 3,
**dadurch gekennzeichnet,**
**dass** der Elektronenstrahl des Rasterelektronenmikroskopischen Teils des SEM/AFM-Nanoprobers spiralförmig an den Zielbereich herangeführt wird.

5. Verfahren nach Anspruch 3,
**dadurch gekennzeichnet,**
**dass** ein kontinuierlicher Elektronenstrahl des Rasterelektronenmikroskopischen Teils des SEM/AFM Nanoprobers in Trajektorien auf dem integrierten Schaltkreis herumgeführt wird der seine Richtung ändert, wenn er den Zielbereich (3) erreicht.

6. Verfahren nach einem der Ansprüche 1 bis 5,
**dadurch gekennzeichnet,**
**dass** die Abbildung des Rasterelektronenmikroskopischen Teils des SEM/AFM-Nanoprobers und eine nachfolgende Re-Positionierung des Spitzen dazu genutzt werden, die Spitzen Schritt für Schritt an den Rand des Zielbereiches heranzuführen.

7. Verfahren nach einem der Ansprüche 1 bis 6,
**dadurch gekennzeichnet,**
**dass** der Rasterelektronenmikroskopische Teil des SEM/AFM-Nanoprobers 50 nm bis 10 nm an den Zielbereich herangeführt wird.

8. Verfahren nach einem der Ansprüche 1 bis 7,
**dadurch gekennzeichnet,**
**dass** von dem Rasterkraftmikroskopischen Teil des SEM/AFM-Nanoprobers wenigstens teilweise Flächenelemente des Nicht-Zielbereiches untersucht werden.

9. Verfahren nach einem der Ansprüche 1 bis 8,
**dadurch gekennzeichnet,**
**dass** der Zielbereich komplett mit dem rasterkraftmikroskopischen Teil des SEM/AFM-Nanoprobers untersucht wird.
